# EUROPEAN PATENT APPLICATION

(11) **EP 1 311 025 A2**
(43) Date of publication of application: **14.05.2003**
(21) Application number: 02013476.3
(22) Date of filing: 14.06.2002
(51) Int. Cl.: H01R 12/08

(54) **Electronic-part mounting structure and mounting method therefor**

(30) Priority: 31.10.2001 JP 2001334936
(71) Applicant: THE FURUKAWA ELECTRIC CO., LTD., Tokyo (JP)
(72) Inventor: Enomoto, Noritsugu, Chiyoda-ku, Tokyo (JP); Suzuki, Yoshiyuki, Chiyoda-ku, Tokyo (JP); Sakata, Kazumasa, Chiyoda-ku, Tokyo (JP); Tamaki, Kazuya, Chiyoda-ku, Tokyo (JP); Nakatani, Yoshimi, Chiyoda-ku, Tokyo (JP); Fujisaki, Atsushi, Chiyoda-ku, Tokyo (JP)
(74) Representative: Modiano, Guido, Dr.-Ing.

(57) **Abstract**

An electronic-part mounting structure includes a wiring circuit (3) comprised of wiring conductors (2) covered with an insulation, an electronic part (4) having connecting conductors (5), disposed on the wiring circuit so as to be aligned with the wiring conductors of the wiring circuit, and connecting members (6) for connecting the wiring conductors with the connecting conductors. Each connecting member has crimp pieces (7) thereof extending through the insulation and the wiring conductor of the wiring circuit to which distal ends of the crimp pieces are bent and cramped. The connecting conductor is held between the connecting member and the wiring circuit and electrically connected to the wiring conductor through the connecting member.

## Description

### BACKGROUND OF THE INVENTION

### Technical Field

The present invention relates to an electronic-part mounting structure and a mounting method therefor.

### Related Art

Electric or electronic equipment is provided with a wiring circuit, such as a wiring board and a printed circuit board, on which electric or electronic parts (hereinafter, collectively referred to as electronic parts) are mounted. For instance, a wiring circuit comprised of a bus bar obtained by stamping a copper plate into a required pattern is employed in a vehicle-mounted electronic equipment for the reason that such a wiring circuit permits a power circuit and a signal circuit to be mixedly arranged therein, through which circuits ten or more amperes of current and several amperes of current flow, respectively.

In order to mount electronic parts on wiring circuits of various kinds, a connecting conductor, such as a lead wire or a connecting terminal, of an electronic part is soldered to a wiring board in a condition that the connecting conductor is inserted to a through hole formed in the wiring board or is abutted to a conductor of the wiring board. Similarly, in mounting an electronic part on a bus bar, a connecting conductor of the electronic part is soldered to the bus bar, with the connecting conductor abutted to the bus bar.

According to the aforementioned conventional mounting methods, however, molten solder can apply thermal affections on an electronic part and cracks can be produced in a solder connection to cause faulty electrical continuity. To obviate this, strict control must be made in the soldering process. Further, a wiring circuit, constituted by a wiring board, a printed circuit board or a bus bar, is poor in flexibility, making it difficult to carry out wiring in a narrow space or three-dimensional wiring.

In this regard, a flexible printed circuit (FPC) or a flexible flat cable (FFC), which is comprised of wiring conductors covered with an insulation, may be used as a wiring circuit. In mounting an electronic part on an FPC or an FFC, generally, the insulation of the FPC or FFC is peeled off at a portion to which the electronic part is to be mounted, and then a connecting conductor of the electronic part is abutted and soldered to the exposed wiring conductor. The FPC or FFC is suitable to carry out wiring in a narrow space or in three-dimensional wiring, but entails effort to peel off the insulation from the FPC or FFC.

### SUMMARY OF THE INVENTION

An object of the present invention is to provide an electronic-part mounting structure and a mounting method therefor, which are capable of mounting an electronic part on a wiring circuit without the need of carrying out soldering.

According to one aspect of the present invention, an electronic-part mounting structure is provided, which comprises: a wiring circuit having an insulation and a wiring conductor arranged in or arranged on the insulation; an electronic part having an electronic-part main portion and a connecting conductor extending therefrom; and a connecting member having a connecting-member main portion and a crimp piece formed integrally therewith and extending through the wiring circuit in a thickness direction thereof. The crimp piece has a distal end thereof bent toward and cramped to the wiring circuit. The connecting member is electrically connected with the wiring conductor of the wiring circuit and the connecting conductor of the electronic part, and holds the connecting conductor between itself and the wiring circuit.

According to the mounting structure of this invention, a connecting conductor of an electronic part is electrically connected with a wiring conductor of a wiring circuit by a connecting member, and the connecting conductor is held between the connecting member and the wiring circuit, and therefore, the electronic part can be mounted to the wiring circuit without the need of carrying out soldering. As a result, thermal affection of molten solder to the electronic part can be prevented, and faulty electrical continuity caused by a crack in a solder connection can be prevented. By using a flexible wiring circuit, wiring in a narrow space and three-dimensional wiring can be easily carried out, and ease of mounting a wiring circuit mounted with an electronic part to a housing can be improved. By extending the crimp piece of the connecting member through the wiring conductor of the wiring circuit, the connecting conductor of the electronic part can be electrically connected through the connecting member to the wiring conductor, without the need of peeling off the insulation from the wiring circuit in advance. If necessary, a conductor of a covered wire can be held between the connecting member and the wiring circuit, together with the connecting conductor of the electronic part, and can be electrically connected to the wiring conductor of the wiring circuit.

According to another aspect of the present invention, a method for mounting an electronic part to a wiring circuit is provided, which comprises the steps of: (a) arranging a connecting conductor of the electronic part on the wiring circuit in alignment with a wiring conductor of the wiring circuit; (b) piercing a crimp piece of a connecting member into the wiring circuit to extend therethrough in a thickness direction thereof; and (c) bending the pierced crimp piece toward the wiring circuit so as to be cramped thereto, thereby electrically connecting the connecting member with the wiring conductor and the connecting conductor and holding the connecting conductor between the connecting member and the wiring circuit.

According to the mounting method of this invention, advantages similar to those achieved by the mounting structure of this invention can be attained. That is, an electronic part can be mounted to a wiring circuit, without the need of carrying out soldering, thereby eliminating thermal affection of molten solder to the electronic part and faulty electrical continuity caused by a crack produced in a solder connection. Use of a flexible wiring circuit makes it easy to carry out wiring in a narrow space and three-dimensional wiring, and improves ease of mounting a wiring circuit mounted with an electronic part to a housing. The crimp piece of the connecting member when extended through the wiring conductor of the wiring circuit makes it possible to efficiently mount an electronic part to the wiring circuit, without the need of peeling off beforehand an insulation from the wiring circuit. According to a preferred embodiment wherein distal ends of crimp pieces of a connecting member are bent, with a connecting conductor of an electronic part disposed between crimp pieces that are extended in advance through a wiring conductor of the wiring circuit, the wiring conductor, the crimp pieces and the connecting conductor can be accurately and easily positioned and connected to one another. According to another preferred embodiment wherein a conductor of a covered wire is held between a connecting member and a wiring circuit together with a connecting conductor of an electronic part, the connection between the wiring conductor and the conductor of the covered wire can be achieved together with the connection between the wiring conductor and the connecting conductor. Furthermore, the wiring conductor, the crimp piece, the connecting conductor and the conductor of the covered wire can be accurately and easily positioned and connected with one another.

### BRIEF DESCRIPTION OF THE DRAWINGS

Fig. 1 is a perspective view showing an electronic-part mounting structure according to a first embodiment of this invention;
Fig. 2 is an enlarged perspective view of a connecting member shown in Fig. 1;
Fig. 3 is a side view of the mounting structure shown in Fig. 1;
Fig. 4 is a sectional view taken along line IV-IV shown in Fig. 3;
Fig. 5 is a perspective view showing a mounting structure according to a second embodiment of this invention;
Fig. 6 is a sectional view of the mounting structure shown in Fig. 5;
Fig. 7 shows an example where flexible wiring circuits each mounted with an electronic part are installed on a housing;
Fig. 8 is a plan view showing a mounting structure according to a third embodiment of this invention;
Fig. 9 is a perspective view showing a connecting member used in a mounting structure according to a fourth embodiment of this invention;
Fig. 10 is a perspective view showing the mounting structure of the fourth embodiment;
Fig. 11 is a sectional view taken along line XI-XI shown in Fig. 10;
Fig. 12 is a sectional view showing a mounting structure according to a fifth embodiment of this invention;
Fig. 13 is a perspective view showing a connecting member used in a mounting structure according to a sixth embodiment of this invention;
Fig. 14 is a sectional view showing the mounting structure according to the sixth embodiment;
Fig. 15 is a sectional view showing a mounting structure according to a seventh embodiment of this invention;
Fig. 16 is a sectional view showing a mounting structure according to an eighth embodiment of this invention;
Fig. 17 is a section view of a mounting structure according to a ninth embodiment of this invention;
Fig. 18 is a perspective view showing a connecting member used in a mounting structure according to a tenth embodiment of this invention;
Fig. 19 is a perspective view of the mounting structure of the tenth embodiment;
Fig. 20 is a front view of the mounting structure as viewed from a joint side;
Fig. 21 is a perspective view of a connecting member used in a mounting structure according to an eleventh embodiment of this invention; and
Fig. 22 is a perspective view of a mounting structure according to the eleventh embodiment.

### DETAILED DESCRIPTION

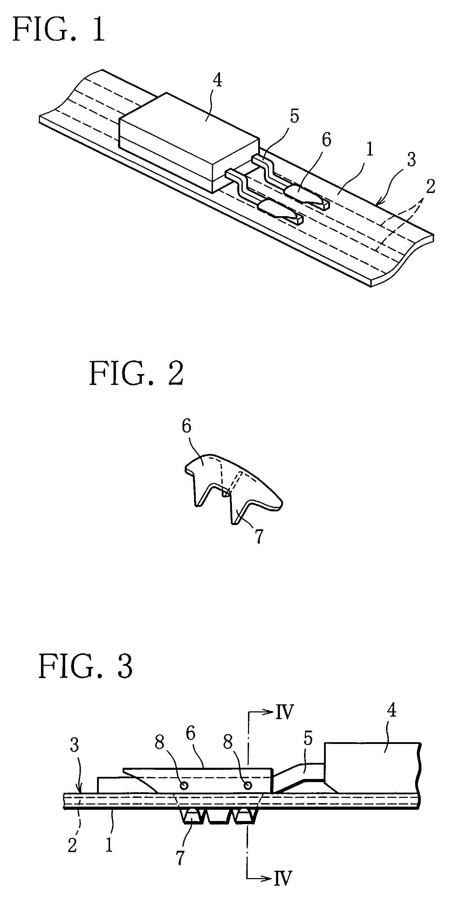

With reference to Figs. 1-4, an electronic-part mounting structure on a wiring circuit, according to a first embodiment of the present invention, will be explained.

The mounting structure of the present embodiment comprises a flexible wiring circuit 3 comprised of, e.g., a flexible flat cable and serving as a wiring circuit. An electronic part 4 comprised of, e.g., a Hall device is disposed on an upper face of the wiring circuit 3. The wiring circuit 3 is constituted by a flat insulation 1 and a plurality of, e.g., two flat wiring conductors 2 that are covered with the insulation 1 and electrically insulated from one another by the insulation. The electronic part 4 has two lead wires (more generally, connecting conductors) 5 extending from a main portion 4a of the electronic part 4. The connecting conductors 5 are connected to the wiring conductors 2 of the wiring circuit 3 by means of connecting members 6 made of an electrically conductive material and having appropriate rigidity.

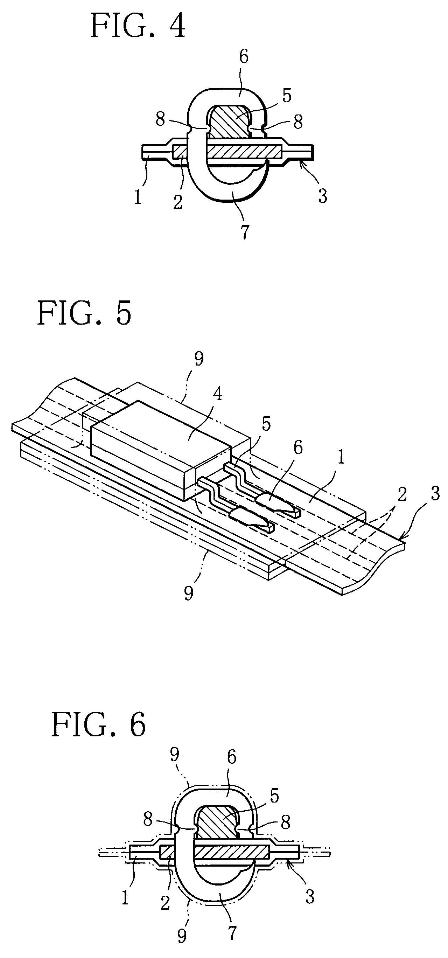

As shown in Fig. 2, each connecting member 6 is comprised of a connecting-member main portion 6a and a plurality of, e.g., three crimp pieces 7 formed integrally therewith. One of the crimp pieces 7 extends downward from one side edge of the connecting-member main portion 6a, the remaining two crimp pieces 7 extend downward from another end edge thereof. As shown in Fig. 4, the connecting-member main portion 6a is disposed to abut against an upper face of the connecting conductor 5 of the electronic part 4, and the crimp pieces 7 extend along the both side faces of the connecting conductor 5 and then extend through the wiring circuit 3. Each crimp piece 7 of the connecting member 6 has a distal end thereof bent from one side to the other side as viewed in the width direction of the connecting member 6, so that a distal end of the crimp piece 7 is in contact with a lower face of the wiring circuit 3. In Fig. 4, the crimp piece 7 provided at one side edge of the connecting member 6 is shown in a cramped state. The crimp pieces 7, provided at the other end edge of the connecting member 6 and located at cross-sectional positions different from that of the illustrated crimp piece, are cramped to the wiring circuit 3 in the same manner. Each crimp piece 7 is formed at its inner face with a projecting bead 8 which is in urged contact with an outer face of the connecting conductor 5. As a result, the connecting conductor 5 is fixed to an upper face of the wiring circuit 3 and electrically connected through the connecting member 6 with the wiring conductor 2 associated therewith.

The following is an explanation of an example of a mounting method to assemble the aforementioned mounting structure.

This mounting method is implemented with use of an electronic-part mounting apparatus. Although no illustration is given, the electronic-part mounting apparatus comprises a holder having chucks for holding a wiring circuit 3, a presser disposed above the wiring circuit 3 held by the holder and movable vertically with respect to the wiring circuit, and a receiver disposed below the wiring circuit 3 held by the holder and movable vertically and horizontally with respect to wiring circuit 3. The receiver is formed with a pair of vertical grooves for individually receiving the crimp piece 7 formed at the one side edge of the connecting member 6 and the two crimp pieces 7 formed at the other side edge thereof, and is formed with a semi-cylindrical groove at a location away from the vertical grooves.

In mounting an electronic part 4 on a wiring circuit 3 with use of the mounting apparatus, the wiring circuit 3 is first held by the holder, and then the electronic part 4 is disposed on an upper face of the wiring circuit 3 in alignment with a corresponding one of the wiring conductors 2 of the wiring circuit 3.

Next, the main portion 6a of the connecting member 6 is held by the presser of the mounting apparatus, with the crimp pieces 7 directed downward. Then, the presser is driven to position the connecting member 6 such that the connecting-member main portion 6a is aligned with the corresponding one connecting conductor 5 of the electronic part 4. Next, the presser is moved downward to cause the crimp pieces 7 of the connecting member 6 to move downward along the side faces of the connecting conductor 5. By further moving the presser downward, the crimp pieces 7 are pierced into the wiring circuit 3 and extend therethrough, to be received in the vertical grooves formed in the receiver of the mounting apparatus.

Next, the receive is moved downward so that the crimp pieces 7 are released from the vertical grooves of the receiver. Subsequently, the receiver is moved horizontally so that the crimp pieces 7 are aligned with the semi-cylindrical groove of the receiver, and then the receiver is moved upward. As a result, the crimp pieces 7 are bent along a semi-cylindrical face of the semi-cylindrical groove formed in the receiver, and then distal ends of the crimp pieces 7 are brought in urged contact with a lower face of the wiring circuit 3, whereby the crimp pieces 7 are cramped to the wiring circuit 3. As a consequence, the one connecting conductor 5 of the electronic part 4 is fixed and electrically connected to the corresponding one wiring conductor 2 of the wiring circuit 3 by the connecting member 6. Similarly, another connecting conductor 5 of the electronic part 4 is fixed and electrically connected to the other wiring conductor 2 of the wiring circuit 3.

Since the connecting conductors 5 of the electronic part 4 are connected to the wiring conductors 2 of the wiring circuit 3 in the above manner with use of connecting members 6 each having a plurality of crimp pieces 7, the electronic part 4 can be mounted to the wiring circuit 3 without soldering. For this reason, the electronic part 4 is prevented from being applied with thermal affection caused by molten solder, and faulty electrical continuity can be prevented, which would otherwise be caused by the presence of a crack in solder connection. A flexible wiring circuit 3 having flexibility makes it possible to implement wiring in a narrow space and three-dimensional wiring, and improves ease of mounting the wiring circuit to a housing. The crimp pieces 7 of the connecting member 6 pierced into the wring conductors 2 of the wiring circuit 3 electrically connects the connecting conductors 5 of the electronic part 4 with the wiring conductors 2 through the connecting member 6, without the need of an laborious operation of peeling off in advance the insulation 1 from the wiring circuit 3. The provision of a projecting bead 8 formed in an inner face of each crimp piece 7 of the connecting member 6 ensures the aforesaid electrical connection.

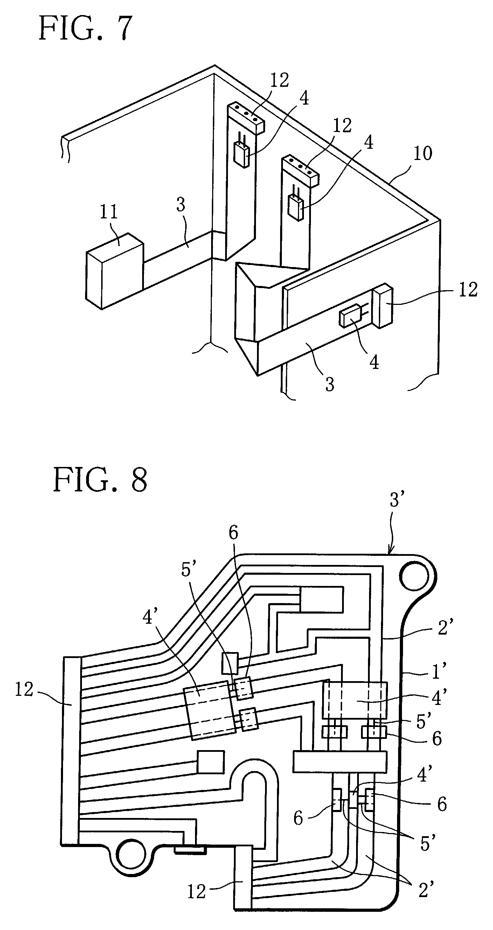

Fig. 7 exemplarily shows an arrangement where flexible wiring circuits 3 each mounted with an electronic part 4 are arranged on inner and outer faces of a housing. In Fig. 7, a plurality of flexible wiring circuits 3 are three-dimensionally installed on the housing 10. One flexible wiring circuit 3 has one end thereof connected to a switch circuit 11 mounted to an inner face of the housing 10 and another end thereof to which a connector 12 is connected. Another flexible wiring circuit 3 has its opposite ends connected to connectors 12.

As shown in Fig 7, a mounting structure in which an electronic part 4 is mounted on a flexible wiring circuit 3 makes it possible to carry out wiring in a narrow space and three-dimensional wiring and improves ease of mounting the wiring circuit to the housing such as a cabinet 10.

With reference to Figs. 5 and 6, an electronic-part mounting structure according to a second embodiment of the present invention will be explained.

The mounting structure of the second embodiment has the same basic structure as that of the first embodiment, and is featured in its improved waterproof.

To this end, the mounting structure of the second embodiment is provided with an insulation 9 that covers surfaces of an electronic part 4, a connecting member 6, and connecting conductors of the electronic part. The insulation is constituted by an insulation sheet, such as plastic sheet, rubber sheet, plastic film, or rubber film. Alternatively, it may be a layered insulation sheet provided at its one side with an adhesive layer. An insulation 9 provided with no adhesive layer is adhered using adhesive onto an upper face of the wiring circuit 3 so as to cover surfaces of the electronic part 4, its connecting conductors 5 and the connecting member 6. An layered insulation 9 is adhered at its adhesive layer to the wiring circuit 3.

The mounting structure of the second embodiment, which is the same in construction as the first embodiment except for the provision of the insulation 9, may be fabricated by means of the same mounting method used for the first embodiment.

The mounting structure according to the second embodiment is excellent in electrical insulation and waterproof since surfaces of the electronic part 4 and an electrical connection between the electronic part and the wiring circuit 3 are covered with the insulation 9. Moreover, this mounting structure makes it easy to implement wiring in a narrow space and three-dimensional wiring as in the case of the first embodiment and as shown in Fig. 7.

With reference to Fig. 8, a mounting structure according to a third embodiment of this invention will be explained.

The mounting structure of the third embodiment is suitable for use, by way of example, with an electronic controller for vehicle-mounted doors. The mounting structure comprises a wiring circuit 3' having a plate-like insulation 1' on which wiring conductors 2' constituted by a bus bar are provided. The connecting conductors 5' of three electronic parts 4' are connected by means of connecting members 6 to corresponding wiring conductors 2' of the wiring circuit 3', respectively. Although illustrations are omitted, the wiring circuit 3' is formed at, preferably its wiring-conductor formed portions, with through holes that permit the crimp pieces 7 of the connecting member 6 to extend therethrough. The distal end of each crimp piece 7 extends through the through hole formed in the wiring circuit 3' and is cramped to the wiring circuit 3', whereby each electronic part 4' is fixed to the wiring circuit 3' by the connecting member 6 and the connecting conductors 5' of the electronic part 4' are electrically connected to the wiring conductors 2' of the wiring circuit 3'.

As in the first and second embodiments, the mounting structure of the third embodiment makes it possible to mount the electronic part 4' to the wiring circuit 3' without soldering, thereby preventing inconveniences caused by soldering.

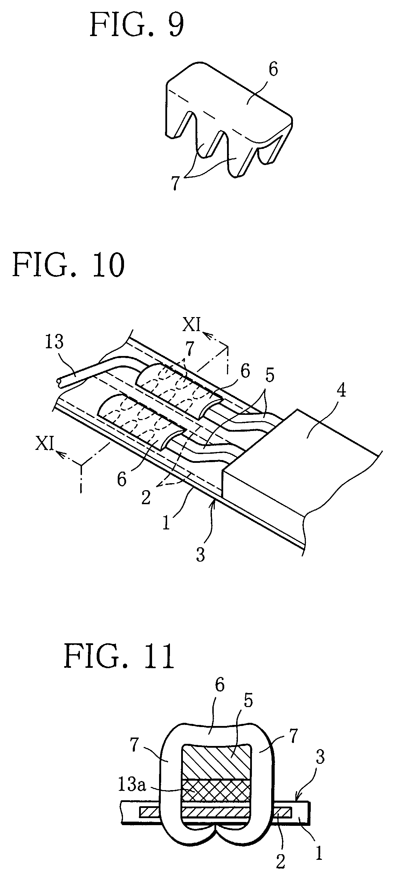

With reference to Figs. 9-11, a mounting structure according to a fourth embodiment of the present invention will be explained.

The mounting structure of the fourth embodiment has the same basic configuration as that of the first embodiment, and is featured in that, using connecting members 6, it establishes a connection between connecting conductors 5 of an electronic part 4 and wiring conductors 2 of a wiring circuit 3 and at the same time a connection between a conductor 13a (Fig. 11) of a covered wire 13 (Fig. 10) and the wiring conductor 2 associated therewith. As shown in Fig. 9, the connecting member 6 of the fourth embodiment is formed at its both side edges with six crimp pieces 7 in total. Each crimp piece 7 formed in one side edge faces a corresponding one of the crimp pieces 7 formed in another side edge. A bead 8 formed in an inner face of each crimp piece 7 is arranged for urged contact with the connecting conductor 5 of the electronic part 4 and the conductor 13a of the covered wire 13. In other respects, the mounting structure of the fourth embodiment is the same as the first embodiment, and thus explanations thereof will be omitted.

In the fourth embodiment, the electronic part 4 can be mounted on the wiring circuit 3 by means of the same mounting method used for the first embodiment. However, the covered wire 13 is first disposed on an upper face of the wiring circuit 3 in alignment with a corresponding one of the wiring conductors 2 of the wiring circuit 3, and then a corresponding one connecting conductor 5 of the electronic part 4 is superimposed on the conductor 13a of the covered wire 13 whose insulation is peeled off in advance. Next, the connecting member 6 is disposed so as to straddle the conductor 13a and the connecting conductor 5 superimposed thereon, and the crimp pieces 7 of the connecting member 6 are pierced into the wiring circuit 3 to extend therethrough. Then, distal ends of the crimp pieces 7 are bent and cramped, thereby fixing the connecting conductor 5 of the electronic part 4 and the conductor 13a of the covered wire 13 to the wiring circuit 3 and the conductor 13a is electrically connected, together with the connecting conductor 5, to the wiring conductor 2 of the wiring circuit 3.

The mounting structure of the fourth embodiment is applicable not only to a flexible wiring circuit 3 but also to a flat wiring board or a printed circuit board that have a flat wiring conductor.

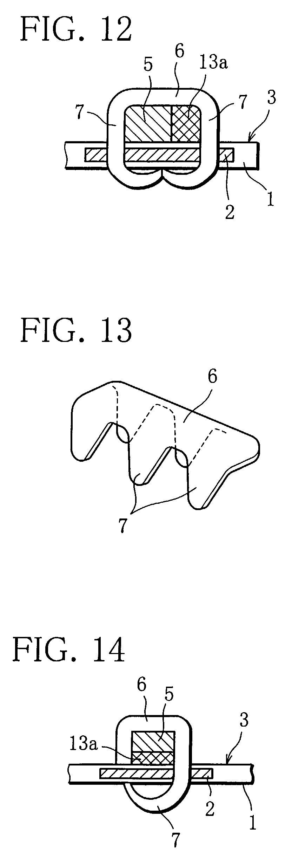

With reference to Fig. 12, a mounting structure of a fifth embodiment of the present invention will be explained.

The mounting structure of the fifth embodiment is similar to the fourth embodiment, but is different therefrom in that a conductor 13a of a covered wire 13 and a connecting conductor 5 of an electronic part 4 are juxtaposed with each other.

In the fifth embodiment, the electronic part 4 can be mounted to the wiring circuit 3 by means of the same mounting method used for the first embodiment. However, the conductor 13a of the covered wire 13 and the connecting conductor 5 of the electronic part 4 are juxtaposed to each other and aligned with the wiring conductor 2 of the wiring circuit 3. As shown in Fig. 12, the connecting member 6 is disposed so as to straddle the conductor 13a and the connecting conductor 5, and then distal ends of the crimp pieces 7 extending through the wiring circuit 3 are cramped as in the case of the first embodiment.

The mounting structure of the fifth embodiment can achieve the same advantages as those attained in the fourth embodiment. In particular, the connecting conductor 5 of the electronic part 4 and the conductor 13a of the covered wire 13 can be disposed on the wiring circuit 3 with stability.

With reference to Figs. 13 and 14, a mounting structure according to a sixth embodiment of the present invention will be explained.

Although the mounting structure of the sixth embodiment differs in that crimp pieces 7 are formed at both side edges of a connecting member 6 in a staggered fashion, they are the same as the fourth embodiment in other respects, producing similar advantages. In the sixth embodiment, the electronic part 4 can be mounted on the wiring circuit 3 in the same manner as in the first embodiment, and hence explanations thereof will be omitted herein.

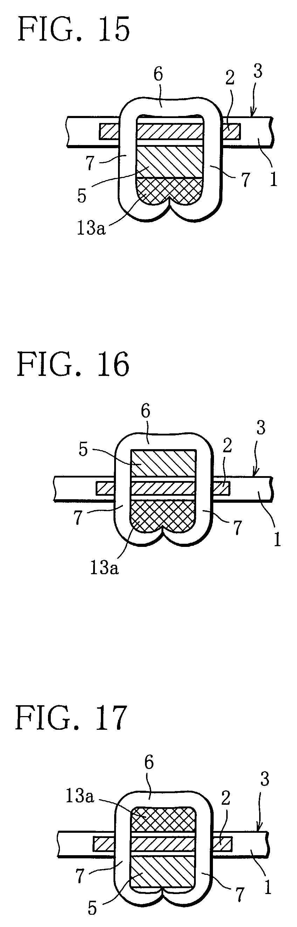

With reference to Fig. 15, a mounting structure of a seventh embodiment of the present invention will be explained.

The mounting structure of the seventh embodiment has the same basic configuration as the fourth embodiment, but is different in that a connecting conductor 5 of an electronic part 4 and a conductor 13a of covered wires 13 are disposed in this order to be close to a lower face of a wiring circuit 3.

The mounting structure of the seventh embodiment can be fabricated with use of a mounting apparatus which is basically the same as that used for the first embodiment.

In mounting an electronic part 4 to a wiring circuit 3, a presser of the mounting apparatus is moved downward in a condition that a connecting member 6 held by the presser is aligned with a wiring conductor 2 of the wiring circuit 3 held by a holder of the mounting apparatus. As a result, crimp pieces 7 of the connecting member 6 pass through the wiring conductor 2 and then distal ends thereof are inserted into vertical grooves formed in a receiver of the mounting apparatus. Subsequently, the receiver is moved downward so as to release the crimp pieces 7 from the vertical grooves. Next, the conductor 13a of the covered wire 13 is disposed in a semi-cylindrical groove formed in the receiver, and the connecting conductor 5 of the electronic part 4 is superimposed thereon. If necessary, the conductor 13a and the connecting conductor 5 are retained in place in the semi-cylindrical groove of the receiver by means of appropriate means.

Next, the receiver is moved horizontally so the semi-cylindrical groove of the receiver is in alignment with the connecting member, and is then moved upward. With the upward movement of the receiver, the distal ends of the crimp piece 7 are gradually received in the semi-cylindrical groove, and hence the connecting conductor 5 and the conductor 13a having received in the semi-cylindrical groove are disposed between distal ends of the crimp pieces 7. Further upward movement of the receiver causes the distal ends of the crimp pieces 7 to be bent along the semi-cylindrical face of the semi-cylindrical groove and cramped as shown in Fig. 15, in a condition that the connecting conductor 5 and the conductor 13a are disposed between the distal ends of the crimp pieces 7.

The mounting structure of the seventh embodiment makes it possible to fix the connecting conductor 5 of the electronic part 4 and the conductor 13a of the covered wire 13 to the wiring circuit 3 and electrically connect the same to the wiring conductor 2 of the wiring circuit 3 by the connecting member 6, as with the fourth embodiment.

Meanwhile, the mounting method of the seventh embodiment for holding the connecting conductor 5 and the conductor 13a by distal ends of the crimp pieces 7 extending through the wiring circuit 3 is applicable to the first embodiment.

With reference to Fig. 16, a mounting structure according to an eighth embodiment of this invention will be explained.

The mounting structure of the eighth embodiment is common to the fourth embodiment in that a connecting conductor 5 of an electronic part 4 and a conductor 13a of a covered wire 13 are connected to a wiring conductor 2 of a wiring circuit 3 by means of a connecting member 6, but differs therefrom in that the connecting conductor 5 is disposed on an upper face of the wiring circuit 3, whereas the conductor 13a is disposed in contact with a lower face of the wiring circuit 3.

In the eighth embodiment, the electronic part 4 can be mounted to the wiring circuit 3 by means of basically the same mounting method used for the fourth embodiment. However, the connecting conductor 5 of the electronic part 4 is disposed on the upper face of the wiring circuit 3 and then the connecting member 6 is positioned so as to straddle the connecting conductor 5. Whereupon, crimp pieces 7 of the connecting member 6 are pierced into the wiring circuit 3, and further, in a condition that the conductor 13a of the covered wire 13 is disposed in advance in a semi-cylindrical groove formed in the receiver of the mounting apparatus, the receiver is moved upward, thereby bending distal ends of the crimp pieces 7 along the semi-cylindrical face of the semi-cylindrical groove of the receiver, whereby the distal ends of the crimp pieces are cramped. As a result, the connecting conductor 5 and the conductor 13a are fixed to the wiring circuit 3 and electrically connected to wiring conductors 2, by means of the connecting member 6.

With reference to Fig. 17, a mounting structure of a ninth embodiment of this invention will be explained.

The mounting structure of the ninth embodiment is different from the eighth embodiment in that a connecting conductor 5 of an electronic part 4 is disposed in contact with a lower face of a wiring circuit 3 and a conductor 13a is disposed on an upper face of the wiring circuit 3, but is the same in other respects. In mounting the electronic part 4 on the wiring circuit 3, the crimp pieces 7 of the connecting member 6 are pierced into the wiring circuit 3 so as to extend therethrough, with the conductor 13a disposed on the upper face of the wiring circuit 3. Further, in a condition that the connecting conductor 5 is received in the semi-cylindrical groove formed in the receiver of the mounting apparatus, the receiver is moved upward to cramp distal ends of crimp pieces 7.

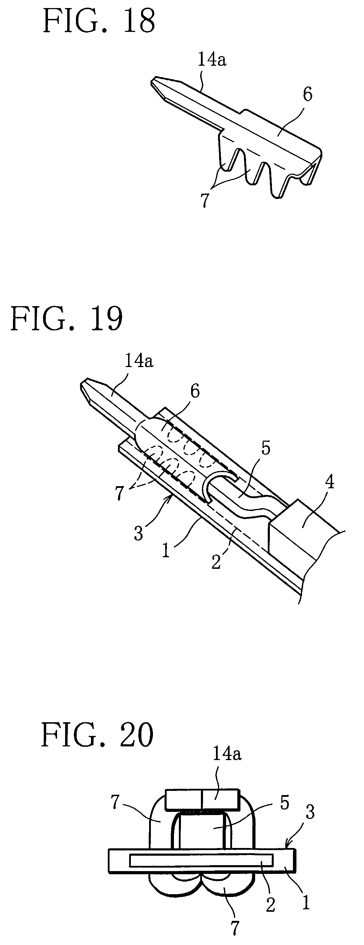

With reference to Figs. 18-20, a mounting structure of a tenth embodiment of the present invention will be explained.

The mounting structure of the tenth embodiment is basically the same as the first embodiment, but is different in that a connecting member 6 is provided with a male joint 14a to permit expansion of a wiring circuit 3.

To this end, as shown in Fig. 18, the connecting member 6 of the tenth embodiment is provided at both side edges of a connecting-member main portion thereof with six crimp pieces 7 in such a manner that each crimp piece at one side edge of the main portion faces a corresponding one of the crimp pieces 7 at another side edge thereof. The connecting member 6 is further provided with a male joint 14 formed integrally with the connecting-member main portion and extending horizontally from a distal end edge of the connecting-member main portion along the axis thereof. The male joint 14a is disposed on the side remote from a connecting conductor 5 of an electronic part 4 with respect to an electronic-part main portion.

Meanwhile, it is not essentially required to extend the joint 14a on the same straight line as the axis of the main portion of the connecting member 6. For instance, the joint 14a may extend obliquely with respect to the axis of the connecting-member main portion. Alternatively, the joint 14a may be formed into an L-shape, so that a distal end thereof extends in parallel to and is disposed apart from the axis of the connecting-member main portion.

In the mounting structure of the tenth embodiment, the electronic part 4 can be mounted on the wiring circuit 3 in the same manner as the first embodiment. Briefly speaking, the electronic part 4 and its connecting conductor 5 are disposed on an upper face of the wiring circuit 3 to be aligned with wiring conductors 2 of the wiring circuit 3, and then the connecting member 6 is positioned such that its crimp pieces 7 are aligned with a corresponding one connecting conductor 5, with the male joint 14a positioned on the side remote from the connecting conductor 5 with respect to the main portion of the electronic part 4. Then, the connecting member 6 is pressed to cause the crimp pieces 7 to be pierced into the wiring circuit 3 and to extend therethrough. Whereupon, distal ends of the crimp pieces are cramped (Fig. 20). As a result, by means of the connecting member 6, the connecting conductor 5 of the electronic part 4 is fixed to the upper face of the wiring circuit 3 and electrically connected with the wiring conductor 2 of the wiring circuit 3.

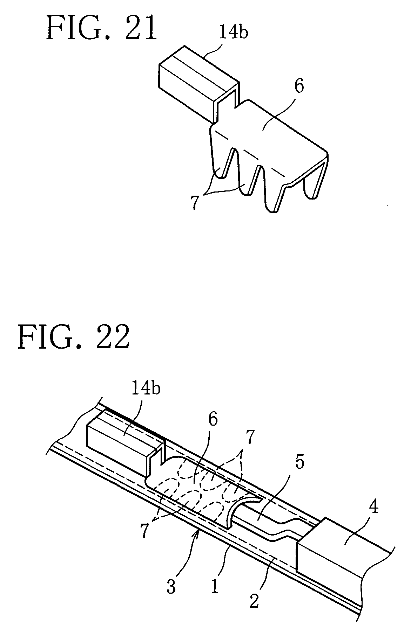

The male joint 14a of the connecting member 6 can be connected to, e.g., a female joint (Figs. 21 and 22) provided in another connecting member, or a female joint (not shown) of an ordinary connector. As understood from the explanations in respect of the first to ninth embodiments, the connecting member of this invention (including one provided with a male or female joint) can be electrically connected with a wiring conductor of a wiring circuit 3, a connecting conductor of an electronic part 4, or a conductor 13a of a covered wire 13. Thus, electrical connection can be established between appropriate ones of conductor elements 2, 5 and 13a through the connecting members 6 individually provided with a male joint 14a and a female joint. In other words, the mounting structure of the tenth embodiment makes it possible to establish the connection between different wiring conductors provided in the same wiring circuit and establish the connection between an arbitrary one wiring conductor of a wiring circuit and that of a different wiring circuit. Thus, expansion can be achieved in electrical connection for wiring circuits and electrical parts.

With reference to Figs. 21 and 22, a mounting structure of an eleventh embodiment of this invention will be explained.

The mounting structure of the eleventh embodiment is basically the same as the tenth embodiment, but differs in that a female joint 14b is provided in the connecting member 6.

As shown in Fig. 21, the connecting member 6 of the eleventh embodiment is provided with six crimp pieces 7 and a female joint 14b extending horizontally from a distal end edge of the connecting-member main portion along the axis thereof and disposed on the side remote from a connecting conductor of the electronic part 4 with respect to an electronic-part main portion. In the meantime, the female joint 14b is not required of being extended on the same straight line as the axis of the connecting-member main portion and may be modified as in the tenth embodiment.

In the mounting structure of the eleventh embodiment, the electronic part 4 can be mounted to the wiring circuit 3 as in the case of the tenth embodiment, so that explanations therefor will be omitted.

The female joint 14b of the connecting member 6 can be connected with, e.g., a male joint (Figs. 18-20) provided in another connecting member and can be utilized for expansion of electrical connection for wiring circuits and electronic parts.

The electronic-part mounting structure to a wiring circuit and a mounting method therefor according to the present invention are not limited to those disclosed in the first through eleventh embodiments, and may be modified in various manners.

For instance, in the first, second and fourth through eleventh embodiments, a flexible wiring circuit 3 may be replaced by a wiring circuit 3' having a bus bar according to the third embodiment, whereby an electronic part 4 or a covered wire 13 can be mounted to a wiring circuit 3' in various ways, without soldering.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1. An electronic-part mounting structure, comprising:
a wiring circuit having an insulation and a wiring conductor arranged in or arranged on the insulation;
an electronic part having an electronic-part main portion and a connecting conductor extending therefrom; and
a connecting member having a connecting-member main portion and a crimp piece formed integrally therewith and extending through the wiring circuit in a thickness direction thereof, said crimp piece having a distal end thereof bent toward and cramped to the wiring circuit, said connecting member being electrically connected with the wiring conductor of the wiring circuit and the connecting conductor of the electronic part, and holding the connecting conductor between the connecting member and the wiring circuit.

2. The mounting structure according to claim 1, wherein said crimp piece of said connecting member extends through the wiring conductor of said wiring circuit.

3. The mounting structure according to claim 1, wherein said wiring circuit is comprised of a flexible wiring circuit having a flat insulation and a flat wiring conductor covered with the flat insulation.

4. The mounting structure according to claim 1, wherein said wiring circuit has a bus bar formed on the insulation and a through hole formed therein for permitting the crimp piece of said connector member to extend therethrough, and said through hole extends through the bus bar of said wiring circuit.

5. The mounting structure according to claim 1, wherein said connecting member has a first crimp piece extending from one side edge of the connecting-member main portion and a second crimp piece extending from another side edge thereof, and the connecting conductor of said electronic part is held between the connecting-member main portion, the first crimp piece, the second crimp piece and said wiring circuit.

6. The mounting structure according to claim 1, wherein said connecting member has a first crimp piece extending from one side edge of the connecting-member main portion and a second crimp piece extending from another side edge thereof, and the mounting structure further includes a covered wire having a conductor thereof held, together with the connecting conductor of said electronic part, between the connecting-member main body, the first crimp piece, the second crimp piece and said wiring circuit.

7. The mounting structure according to claim 6,wherein one conductor out of the connecting conductor of said electronic part and the conductor of said covered wire is disposed on a first face of said wiring circuit and the other conductor is superimposed on the one conductor, and
the connecting conductor of said electronic part and the conductor of said covered wire are held between the connecting-member main portion , the first crimp piece, the second crimp piece and the first face of said wiring circuit.

8. The mounting structure according to claim 6, wherein one conductor out of the connecting conductor of said electronic part and the conductor of said covered wire is disposed in contact with a second face of said wiring circuit and the other conductor is superimposedly arranged with the one conductor, and
the connecting conductor of said electronic part and the conductor of said covered wire are held between distal ends of the first and second crimp pieces of said connecting member and the second face of said wiring circuit.

9. The mounting structure according to claim 6, wherein one conductor out of the connecting conductor of said electronic part and the conductor of said covered wire is disposed on a first face of said wiring circuit and held between the connecting-member main portion, the first crimp piece, the second crimp piece and the first face of said wiring circuit, and the other conductor is disposed in contact with a second face of said wiring circuit and held between distal ends of the first and second crimp pieces of said connecting member and the second face of said wiring circuit.

10. The mounting structure according to claim 1, further including:
a covered wire having a conductor thereof juxtaposed on said wiring circuit with the connecting conductor of said electronic part,
wherein the connecting conductor and the conductor are held between said connecting member and said wiring circuit.

11. The mounting structure according to claim 1, wherein the crimp piece is formed at its inner face with a projecting bead.

12. The mounting structure according to claim 1, further including:
an insulation that covers a surface of the connecting conductor of said electronic part and a surface of said connecting member.

13. The mounting structure according to claim 1, wherein said connecting member has a joint formed integrally with the connecting-member main portion and extending outwardly from a distal end edge of the connecting-member main portion.
